(19) Europäisches Patentamt / European Patent Office / Office européen des brevets

(11) **EP 4 362 255 B1**

(12) **EUROPEAN PATENT SPECIFICATION**

(45) Date of publication and mention
of the grant of the patent:
**18.02.2026  Bulletin 2026/08**

(51) International Patent Classification (IPC):
*H02H 3/20* (2006.01)        *H02H 7/122* (2006.01)
*G01R 19/165* (2006.01)

(21) Application number: **22216271.1**

(22) Date of filing: **23.12.2022**

(52) Cooperative Patent Classification (CPC):
**H02H 7/1222; G01R 19/16547;** G01R 19/003;
G01R 19/0084; G01R 19/10; H02H 3/20

(54) **FORSMARK EFFECT MONITORING METHOD FOR NUCLEAR CLASS ELECTRICAL EQUIPMENT**

FORSMARK-EFFEKT-ÜBERWACHUNGSVERFAHREN FÜR NUKLEARE ELEKTRISCHE AUSRÜSTUNG

PROCÉDÉ DE SURVEILLANCE D'EFFET DE FORSMARK POUR ÉQUIPEMENT ÉLECTRIQUE DE CLASSE NUCLÉAIRE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:  **31.10.2022  CN 202211350617**

(43) Date of publication of application:
**01.05.2024  Bulletin 2024/18**

(73) Proprietor: **Kehua Data Co., Ltd
361000 Xiamen Fujian (CN)**

(72) Inventors:
• **WANG, Qunxing**
  **Xiamen, 361000 (CN)**
• **ZHENG, Jinxiang**
  **Xiamen, 361000 (CN)**
• **WU, Wenbin**
  **Xiamen, 361000 (CN)**
• **CHEN, Dong**
  **Xiamen, 361000 (CN)**
• **LAN, Jie**
  **Xiamen, 361000 (CN)**

(74) Representative: **Isarpatent
Patent- und Rechtsanwälte Barth
Charles Hassa Peckmann & Partner mbB
Friedrichstrasse 31
80801 München (DE)**

(56) References cited:
WO-A1-2021/099413    WO-A1-2021/175793
WO-A1-2021/196627    WO-A1-2022/223759

• "NPP Voltage S rge NPP Voltage Surge
Protection ; NPEC_July-2012_HBickel_NPP
Voltage Surge Protection", IEEE DRAFT;
NPEC_JULY-2012_HBICKEL_NPP VOLTAGE
SURGE PROTECTION, IEEE-SA, PISCATAWAY,
NJ USA, vol. npec, 4 August 2012 (2012-08-04),
pages 1 - 18, XP068030077

**Description**

TECHNICAL FIELD

The present application relates to the technical field of electric power, and particularly relates to a Forsmark effect monitoring method and a Forsmark effect monitoring device for a nuclear class electrical equipment, as well as a non-transitory computer readable storage medium.

BACKGROUND

Forsmark effect refers to a sudden change of the surge voltage of the AC input power grid, which causes the DC bus voltage to fluctuate with it, and its fluctuation range exceeds the bearable range of the inverter's device performance, thus causing the interruption or sudden change of the output AC voltage. The Forsmark effect generally exists in the circuits of nuclear class electrical equipment. Due to the sudden change of the AC input power grid (connected power grid), the voltage is transmitted to the DC bus through the rectifier circuit, resulting in a sudden increase of the DC bus voltage, which exceeds the DC input over-voltage protection point of the inverter, leading to output power loss. When the DC bus voltage suddenly increases too high, it may even cause damage to the IGBT tube of the inverter, affecting the normal operation of the system.

In the prior art, the bus voltage of the DC bus of the nuclear class electrical equipment is usually monitored to determine whether the Forsmark effect is generated, but this method is not timely monitoring.

WO 2021/099413 A1 discloses an intelligent electronic device and a method for determining a disturbance condition in a power transmission line.

WO 2022/223759 A1 discloses a computer-implemented method and an intelligent electronic device.

WO 2021/175793 A1 discloses a method and an intelligent electronic device for protecting a power transmission line in response to a fault with a monitored zone in a power transmission system.

WO 2021/196627 A1 discloses a bidirectional converter-based Forsmark effect suppression method and an apparatus.

Document "NPP Voltage Surge Protection" from Dr. John H. Bickel, IEEE DRAFT, NPEC_JULY-2012_HBICKEL_NPP VOLTAGE SURGE PROTECTION, IEEE-SA, PISCATAWAY, NJ USA, vol. npec, 4 August 2012 (2012-08-04), pages 1-18, XP068030077, discloses a NPP voltage surge protection.

SUMMARY

The present application provides a Forsmark effect monitoring method and a Forsmark effect monitoring device for a nuclear class electrical equipment, as well as a non-transitory computer readable storage medium, as defined in the appended set of claims, which can solve the problem of the Forsmark effect in circuit of the nuclear class electrical equipment caused by the untimely Forsmark effect monitoring of the nuclear class electrical equipment.

A first aspect of embodiments of the present application provides a Forsmark effect monitoring method for a nuclear class electrical equipment, which includes:

acquiring a modulus value of a power grid voltage input to the nuclear class electrical equipment according to a preset monitoring period;

matching a current monitoring period with a Yth monitoring period before the current monitoring period, and calculating a change ratio of the modulus value of the current monitoring period to the modulus value of a matched monitoring period; and

when the change ratio corresponding to the current monitoring period and Y-1 change ratios corresponding to Y-1 monitoring periods before the current monitoring period are all greater than a change protection value, determining that the nuclear class electrical equipment will have the Forsmark effect;

wherein calculating the change ratio of the modulus value of the current monitoring period to the modulus value of the matched monitoring period comprises:

calculating the change ratio of the modulus value of the current monitoring period to the modulus value of the matched monitoring period based on a change ratio calculation formula; and

the change ratio calculation formula is:

$$d_Z = \left| \frac{(\mathrm{MagBuf}[Z] - \mathrm{MagBuf}[Z-Y])}{\mathrm{MagBuf}[Z-Y]} \right|;$$

wherein $d_Z$ represents the change ratio of the modulus value of a Zth monitoring period, MagBuf[Z] represents the modulus value of the Zth monitoring period, MagBuf[Z-Y] represents the modulus value of the Yth monitoring period before the Zth monitoring period; and

wherein acquiring the modulus value of the power grid voltage input to the nuclear class electrical equipment according to the preset monitoring period comprises:

calculating the modulus value of the power grid voltage input to the nuclear class electrical equipment based on a change calculation formula; and

the change calculation formula is:

$$\begin{cases} Alpha = [U_{uv} - 0.5(U_{vw} + U_{wu})] \cdot \sqrt{\dfrac{2}{3}} \\ Bete = [U_{uw} - U_{wu}] \cdot \sqrt{\dfrac{1}{2}} \\ Magnitude = Alpha \cdot Alpha + Bete \cdot Bete \end{cases};$$

wherein $U_{uv}$, $U_{uw}$ and $U_{wu}$ represent a three-phase voltage respectively; *Magnitude* represents the modulus value of the power grid voltage.

A second aspect of embodiments of the present application provides a Forsmark effect monitoring device for a nuclear class electrical equipment, which includes:

a modulus value calculation module, being configured for acquiring a modulus value of a power grid voltage input to the nuclear class electrical equipment according to a preset monitoring period;

a change ratio calculation module, being configured for matching a current monitoring period with a Yth monitoring period before the current monitoring period, and calculating a change ratio of the modulus value of the current monitoring period to the modulus value of a matched monitoring period; and

a change monitoring module, being configured for when the change ratio corresponding to the current monitoring period and Y-1 change ratios corresponding to Y-1 monitoring periods before the current monitoring period are all greater than a change protection value, determining that the nuclear class electrical equipment will have the Forsmark effect;

wherein the change ratio calculation module is specifically configured for:

calculating the change ratio of the modulus value of the current monitoring period to the modulus value of the matched monitoring period based on a change ratio calculation formula; and

the change ratio calculation formula is:

$$d_Z = \left| \frac{(\mathrm{MagBuf}[Z] - \mathrm{MagBuf}[Z-Y])}{\mathrm{MagBuf}[Z-Y]} \right|;$$

wherein $d_Z$ represents the change ratio of the modulus value of a Zth monitoring period, MagBuf[Z] represents the modulus value of the Zth monitoring period, MagBuf[Z-Y] represents the modulus value of the Yth monitoring period before the Zth monitoring period; and

wherein the modulus value calculation module is specifically configured for:

calculating the modulus value of the power grid voltage input to the nuclear class electrical equipment based on a change calculation formula; and

the change calculation formula is:

$$\begin{cases} Alpha = [U_{uv} - 0.5(U_{vw} + U_{wu})] \cdot \sqrt{\dfrac{2}{3}} \\[2mm] Bete = [U_{uw} - U_{wu}] \cdot \sqrt{\dfrac{1}{2}} \\[2mm] Magnitude = Alpha \cdot Alpha + Bete \cdot Bete \end{cases};$$

wherein $U_{uv}$, $U_{uw}$ and $U_{wu}$ represent a three-phase voltage respectively; *Magnitude* represents the modulus value of the power grid voltage.

A third aspect of embodiments of the present application provides a non-transitory computer readable storage medium, which stores a computer program, when the computer program is executed by a processor, the steps of the method described in any of the possible implementations of the first aspect above are realized.

Compared with the prior art, the embodiments of the present application has the following beneficial effects: the embodiments of the present application match the current monitoring period with a Yth monitoring period before the current monitoring period, and calculate the change ratio of the current monitoring period to the modulus value of a matched monitoring period; when the change ratio corresponding to the current monitoring period and Y-1 change ratios corresponding to Y-1 monitoring periods before the current monitoring period are all greater than the change protection value, determining that the nuclear class electrical equipment will have the Forsmark effect, which can achieve timely detection of the change of the power grid voltage, thus avoiding devices damage caused by the Forsmark effect in the circuit of the nuclear class electrical equipment. At the same time, the embodiments of the present application can improve the monitoring accuracy of the Forsmark effect by detecting multiple monitoring periods, and ensure the normal operation of the nuclear class electrical equipment.

## BRIEF DESCRIPTION OF THE DRAWINGS

In order to more clearly illustrate the technical solutions in the embodiments of the application, the following description briefly introduces the drawings used in the embodiments or the prior art, and it is obvious that the drawings in the following description are only some embodiments of the application, and that other drawings can be obtained from these drawings by a person skilled in the art without involving any inventive effort.

Fig. 1 is an application scenario diagram of a Forsmark effect monitoring method for a nuclear class electrical equipment provided by an embodiment of the present application;

Fig. 2 is a flow diagram of a Forsmark effect monitoring method for a nuclear class electrical equipment provided by an embodiment of the present application;

Fig. 3 is a schematic diagram of the change ratio calculation of a Forsmark effect monitoring method for a nuclear class electrical equipment provided by an embodiment of the present application;

Fig. 4 is a structural schematic diagram of a Forsmark effect monitoring method for a nuclear class electrical equipment provided by an embodiment of the present application; and

Fig. 5 is a schematic diagram of a terminal provided by an embodiment of the present application.

## DETAILED DESCRIPTION OF ILLUSTRATIVE EMBODIMENTS

In the following description, for the purpose of illustration rather than limitation, specific details such as a specific system structure and technology are set forth in order to provide a thorough understanding of the embodiments of the present application. However, it should be apparent to those skilled in the art that the technical solutions of the present application can also be implemented in other embodiments without these specific details. In other instances, detailed descriptions of well-known systems, devices, circuits, and methods are omitted so as not to obscure the description of the present application with unnecessary detail.

In order to explain the technical solution of the present application, the following will be described through specific embodiments.

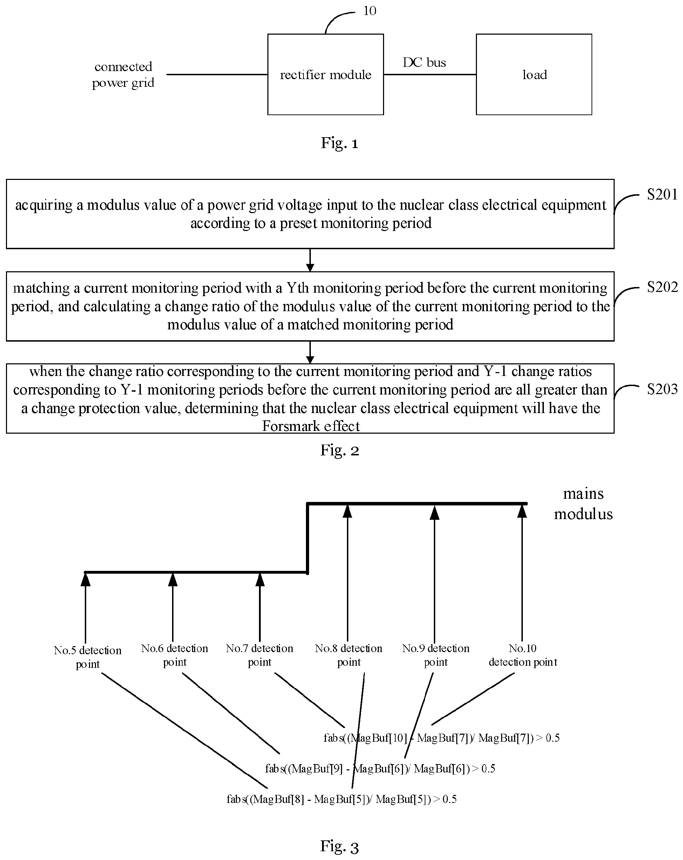

Fig. 1 is an application scenario diagram of a Forsmark effect monitoring method for a nuclear class electrical equipment provided by the embodiment of the present application. As shown in Fig. 1, the nuclear class electrical equipment includes a rectifier module 10; the rectifier module 10 is configured for converting the power grid voltage input to the rectifier module 10 from alternating current to direct current and outputting to a DC bus of the nuclear class electrical equipment.

In the embodiment of the present application, the nuclear class electrical equipment may be an equipment configured with a DC bus and a rectifier module 10, and the rectifier module 10 is configured for converting the alternating current (which may be input from the connected power grid) input to the nuclear class electrical equipment into direct current and outputting to the DC bus of the nuclear class electrical equipment.

In other application scenarios, such as nuclear power plants, the nuclear class electrical equipment is usually equipped with energy storage units (such as battery packs), and its rectifier modules are usually chargers with rectifier function and charging function.

It is apparent to those of ordinary skill in the art that the specific structure of the above nuclear class electrical equipment provided in this embodiment is only an example, and it is not used to define the structure of electrical equipment. In the actual application scenario, other nuclear class electrical equipment that can be connected to the mains power are applicable to this method.

Specifically, because the sudden change of the surge voltage of the AC input power grid will cause the voltage fluctuation of the DC bus of the rectifier module, and when the fluctuation range exceeds the DC over-voltage protection point of the subsequent inverter, the inverter will be damaged or the output will lose power. Therefore, it is necessary to timely and effectively identify the sudden change of the AC power grid voltage, so as to timely protect the nuclear class electrical equipment in case of the sudden change of the power grid voltage.

As shown in Fig. 2, Fig. 2 shows the implementation flow diagram of the Forsmark effect monitoring method for the nuclear class electrical equipment provided in the embodiment of the present application, and details are as follows:

S101: acquiring a modulus value of a power grid voltage input to the nuclear class electrical equipment according to a preset monitoring period.

According to the invention, the specific implementation process of S101 includes:

calculating the modulus value of the power grid voltage input to the nuclear class electrical equipment based on a change calculation formula; and
the change calculation formula is:

$$\begin{cases} Alpha = [U_{uv} - 0.5(U_{vw} + U_{wu})] \cdot \sqrt{\dfrac{2}{3}} \\ Bete = [U_{uw} - U_{wu}] \cdot \sqrt{\dfrac{1}{2}} \\ Magnitude = Alpha \cdot Alpha + Bete \cdot Bete \end{cases} ;$$

where $U_{uv}$, $U_{uw}$ and $U_{wu}$ represent a three-phase voltage respectively; *Magnitude* represents the modulus value of the power grid voltage.

In this embodiment, when the power grid voltage is stable, the modulus value is a constant value, and when the power grid voltage suddenly changes, the modulus value will change accordingly. Based on this principle, this embodiment calculates the modulus value of the power grid voltage in each monitoring period in real time, which can simply and accurately determine whether the power grid voltage has a sudden change based on the change of the modulus value.

Specifically, a first array MagBuf is defined, and the modulus value is stored in the first array MagBuf each time the modulus value is calculated.

S102: matching a current monitoring period with a Yth monitoring period before the current monitoring period, and calculating a change ratio of the modulus value of the current monitoring period to the modulus value of a matched monitoring period.

S103: when the change ratio corresponding to the current monitoring period and Y-1 change ratios corresponding to Y-1 monitoring periods before the current monitoring period are all greater than a change protection value, determining that the nuclear class electrical equipment will have the Forsmark effect.

In this embodiment, if only the change of the modulus value of the power grid voltage in the current monitoring period is used to determine whether there is a sudden change in the power grid voltage, there may be a case of error in individual data acquisition of the power grid voltage, which may lead to misjudgment. Therefore, this embodiment continuously calculates the change ratio of modulus value for multiple monitoring periods to improve the accuracy of the Forsmark effect monitoring of the nuclear class electrical equipment.

Specifically, this embodiment can monitor the change ratios of the modulus values of multiple monitoring periods by setting monitoring period groups. Specifically, for the current monitoring period, the sliding window method is used to determine the monitoring period group of the current monitoring period. When monitoring the change ratio of the modulus value corresponding to the current monitoring period, first select the current monitoring period and the previous Y-1 monitoring periods to form the current monitoring period group of the current monitoring period, then the previous monitoring period group is the monitoring period group consisting of the previous Y monitoring periods to the previous 2Y-1 monitoring periods. The previous Y-1 monitoring periods, the previous Y monitoring periods and the previous 2Y-1 monitoring periods are all monitoring periods before the current monitoring period. Then the monitoring periods of the two monitoring period groups are matched one-to-one; specifically, the matching relationship between the two monitoring period groups is: MagBuf[Z] matches MagBuf[Z-Y], MagBuf[Z-1] matches MagBuf[Z-Y-1], ······, MagBuf[Z-Y+1] matches MagBuf[Z-2Y+1].

In this embodiment, the sliding window is used in the first array to match the monitoring period group for each monitoring period, so as to calculate a group of change ratios corresponding to each monitoring period group, so as to improve the accuracy and timeliness of mains change detection.

In one possible embodiment, after S101, the method provided in this embodiment further includes: determining whether a first array has a remaining storage location; when the first array has the remaining storage location, storing the modulus value of the current monitoring period in an empty location of the first array according to a storage order of the first array; and when the first array has no remaining storage location, deleting the modulus value of the monitoring period first stored in the first array, moving remaining modulus value of the first array forward by one location to form an empty location, and storing the modulus value of the current monitoring period in the empty location to update the first array.

In one possible embodiment, after S101, the method provided in this embodiment further includes: determining whether a first array has a remaining storage location; and when the first array has no the remaining storage location, deleting the modulus value of the monitoring period first stored in the first array, and storing the modulus value of the current monitoring period in a location of a newly deleted modulus value, the first array comprising at least 2Y storage locations.

Specifically, the first array may be an array consisting of 2Y storage locations. After calculating the modulus value of the current monitoring period, determine whether the first array has any remaining storage locations. If the first array has any remaining storage locations, store the modulus value of the current monitoring period in the remaining storage locations according to the storage order of the first array; if the first array has full modulus value, and there is no remaining storage location, the modulus value of the monitoring period first stored in the first array will be deleted, and the modulus value of the current monitoring period will be stored in a new empty storage location. Thus, the storage of the modulus value and the update of the first array are realized.

With the above method, this embodiment can not only save the storage space to the greatest extent, but also do not need to move the location of each modulus value every time the modulus value is stored, thus improving the storage efficiency of the modulus value. At the same time, when calculating the change ratio, it is only necessary to determine the location of the modulus value in the array when the modulus value is updated, so as to ensure the calculation efficiency of the change ratio.

According to the invention, the specific implementation process of S102 includes:

calculating the change ratio of the modulus value of the current monitoring period to the modulus value of the matched monitoring period based on a change ratio calculation formula; and
the change ratio calculation formula is:

$$d_Z = \left| \frac{(\mathrm{MagBuf}[Z] - \mathrm{MagBuf}[Z - Y])}{\mathrm{MagBuf}[Z - Y]} \right|;$$

where $d_Z$ represents the change ratio of the modulus value of a Zth monitoring period, MagBuf[Z] represents the modulus value of the Zth monitoring period, MagBuf[Z-Y] represents the modulus value of the Yth monitoring period before the Zth monitoring period.

As an example, the Y value may be 3 or 4, and the change protection value may be 50% or 60%, which are not limited.

For example, as shown in Fig. 3, taking the change protection value as 0.5, Y as 3, and the location of the current latest modulus value in the array MagBuf as Z=10 as an example, triggering protection must meet the following conditions at the same time:

$$fabs((MagBuf[10] - MagBuf[7])/ MagBuf[7]) > 0.5,$$

$$fabs((MagBuf[9] - MagBuf[6])/ MagBuf[6]) > 0.5,$$

and

$$fabs((MagBuf[8] - MagBuf[5])/ MagBuf[5]) > 0.5.$$

In one possible embodiment, the specific implementation process of S103 includes:
power-off protecting the nuclear class electrical equipment.

In one possible embodiment, the method provided in this embodiment further includes:

obtaining a mains protection time set by a user; and

determining a corresponding Y value based on the mains protection time.

Specifically, users can customize the length of the mains protection time. After obtaining the mains protection time, the terminal converts the mains protection time into Y value based on the duration of the monitoring period, thus improving the adaptability of this method.

The embodiments of the present application match the current monitoring period with a Yth monitoring period before the current monitoring period, and calculate the change ratio of the current monitoring period to the modulus value of a matched monitoring period; when the change ratio corresponding to the current monitoring period and Y-1 change ratios corresponding to Y-1 monitoring periods before the current monitoring period are all greater than the change protection value, determining that the nuclear class electrical equipment will have the Forsmark effect, which can achieve timely detection of the change of the power grid voltage, thus avoiding devices damage caused by the Forsmark effect in the circuit of the nuclear class electrical equipment. At the same time, the embodiments of the present application can improve the monitoring accuracy of the Forsmark effect by detecting multiple monitoring periods, and ensure the normal operation of the nuclear class electrical equipment.

It should be understood that the size of the sequence number of each step in the above embodiments does not mean the order of execution, and the execution order of each process should be determined by its function and internal logic, without any restriction on the implementation process of the embodiments of the present application.

The device embodiment of the present application, for details which are not described in detail, may be referred to the corresponding method embodiment described above.

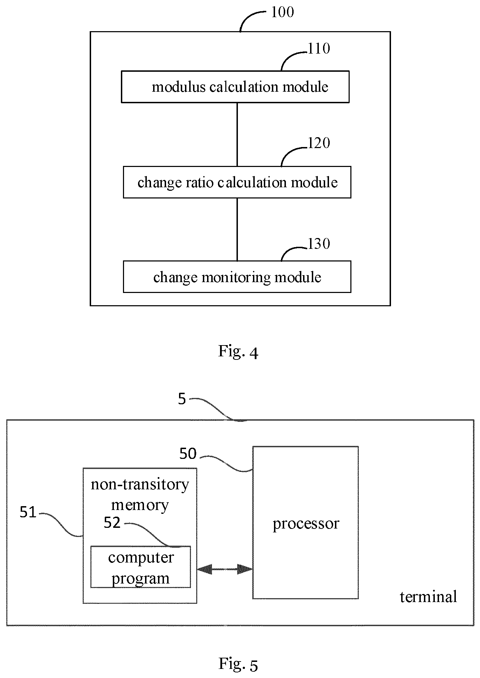

Fig. 4 shows a schematic structural diagram of the Forsmark effect monitoring device of the nuclear class electrical equipment provided by the embodiment of the present application, showing only the relevant part of the embodiment of the present application, as detailed as follows:

As shown in Fig. 4, the Forsmark effect monitoring device 100 of the nuclear class electrical equipment includes:

a modulus value calculation module 110, being configured for acquiring a modulus value of a power grid voltage input to the nuclear class electrical equipment according to a preset monitoring period;

a change ratio calculation module 120, being configured for matching a current monitoring period with a Yth monitoring period before the current monitoring period, and calculating a change ratio of the modulus value of the current monitoring period to the modulus value of a matched monitoring period; and

a change monitoring module 130, being configured for when the change ratio corresponding to the current monitoring period and Y-1 change ratios corresponding to Y-1 monitoring periods before the current monitoring period are all greater than a change protection value, determining that the nuclear class electrical equipment will have the Forsmark effect.

According to the invention, the change ratio calculation module 120 is specifically configured for:

calculating the change ratio of the modulus value of the current monitoring period to the modulus value of the matched monitoring period based on a change ratio calculation formula; and
the change ratio calculation formula is:

$$d_Z = \left| \frac{(\mathrm{MagBuf}[Z] - \mathrm{MagBuf}[Z - Y])}{\mathrm{MagBuf}[Z - Y]} \right|;$$

where $d_Z$ represents the change ratio of the modulus value of a Zth monitoring period, MagBuf[Z] represents the modulus value of the Zth monitoring period, MagBuf[Z-Y] represents the modulus value of the Yth monitoring period before the Zth monitoring period.

According to the invention, the modulus value calculation module 110 is specifically configured for:

calculating the modulus value of the power grid voltage input to the nuclear class electrical equipment based on a change calculation formula; and
the change calculation formula is:

$$\begin{cases} Alpha = [U_{uv} - 0.5(U_{vw} + U_{wu})] \cdot \sqrt{\dfrac{2}{3}} \\ Bete = [U_{uw} - U_{wu}] \cdot \sqrt{\dfrac{1}{2}} \\ Magnitude = Alpha \cdot Alpha + Bete \cdot Bete \end{cases};$$

where $U_{uv}$, $U_{uw}$ and $U_{wu}$ represent a three-phase voltage respectively; *Magnitude* represents the modulus value of the power grid voltage.

In one possible embodiment, the Forsmark effect monitoring device 100 for the nuclear class electrical equipment further includes:
a power-off protection module, being configured for power-off protecting the nuclear class electrical equipment.
In one possible embodiment, the Forsmark effect monitoring device 100 for the nuclear class electrical equipment further includes a modulus value storage module, being configured for:
determining whether a first array has a remaining storage location; and when the first array has no the remaining storage location, deleting the modulus value of the monitoring period first stored in the first array, and storing the modulus value of the current monitoring period in a location of a newly deleted modulus value, the first array comprising at least 2Y storage locations.
In one possible embodiment, the Forsmark effect monitoring device 100 for the nuclear class electrical equipment further includes a Y value setting module, being configured for:

obtaining a mains protection time set by a user; and

determining a corresponding Y value based on the mains protection time.

The embodiments of the present application match the current monitoring period with a Yth monitoring period before the current monitoring period, and calculate the change ratio of the current monitoring period to the modulus value of a matched monitoring period; when the change ratio corresponding to the current monitoring period and Y-1 change ratios corresponding to Y-1 monitoring periods before the current monitoring period are all greater than the change protection value, determining that the nuclear class electrical equipment will have the Forsmark effect, which can achieve timely detection of the change of the power grid voltage, thus avoiding devices damage caused by the Forsmark effect in the circuit of the nuclear class electrical equipment. At the same time, the embodiments of the present application can improve the monitoring accuracy of the Forsmark effect by detecting multiple monitoring periods, and ensure the normal operation of the nuclear class electrical equipment.

The Forsmark effect monitoring device for the nuclear class electrical equipment provided in this embodiment can be used to implement the embodiment of the Forsmark effect monitoring method for the nuclear class electrical equipment. Its implementation principle and technical effect are similar, so this embodiment will not be repeated here.

Fig. 5 is a schematic diagram of a terminal provided by an embodiment of the present application. As shown in Fig. 5, the terminal 5 of the embodiment includes a processor 50, a non-transitory memory 51, and a computer program 52 stored in the non-transitory memory 51 and capable of running on the processor 50. When the processor 50 executes the computer program 52, it realizes the steps in each embodiment of the Forsmark effect monitoring method for the nuclear class electrical equipment, such as steps S101 to S103 shown in Fig. 2. Alternatively, when the processor 50 executes the computer program 52, it realizes the functions of each module/unit in the above device embodiments, such as the functions of modules 110 to 130 shown in Fig. 4.

By way of example, the computer program 52 may be divided into one or more modules/units, which are stored in the non-transitory memory 51 and executed by the processor 50 to complete the present application. The one or more modules/units may be a series of computer program instruction segments capable of performing specific functions, which are used to describe the execution process of the computer program 52 in the terminal 5.

The terminal 5 may be a computing device such as a desktop computer, a laptop, a handheld computer, a cloud server, etc.. The terminal 5 may include, but is not limited to, a processor 50 and a memory 51. Those skilled in the art can understand that Fig. 5 is only an example of the terminal 5, and does not constitute a definition of the terminal 5. It can include more or fewer components than shown in the figure, or combine some components, or different components. For example, the terminal 5 may also include input and output devices, network access devices, buses, and so on.

The processor 50 may be a central processing unit (CPU), other general-purpose processor, digital signal processor (DSP), application specific integrated circuit (ASIC), field programmable gate array (FPGA) or other programmable logic devices, discrete gates or transistor logic devices and discrete hardware components, etc.. A general-purpose processor may be a microprocessor or the processor may also be any conventional processor or the like.

The non-transitory memory 51 may be an internal storage unit of the terminal 5, such as a hard disk or memory of the terminal 5. The non-transitory memory 51 may also be an external storage device of the terminal 5, for example, a plug-in hard disk, a smart media card (SMC), a secure digital (SD) card, a flash card, etc. equipped on the terminal 5. Further, the non-transitory memory 51 may also include both an internal storage unit of the terminal 5 and an external storage device. The non-transitory memory 51 is used for storing the computer program and other programs and data required by the terminal 5. The non-transitory memory 51 may also be used to temporarily store data that has been output or will be output.

Those skilled in the art can clearly understand that, for the convenience and simplicity of description, only the division of the above functional units and modules will be illustrated. In practical applications, the above functional allocation may be completed by different functional units and modules as required, that is, the internal structure of the device is divided into different functional units or modules to complete all or part of the above described functions. Each functional unit and module in the embodiment can be integrated in a processing unit, or each unit can exist physically independently, or two or more units can be integrated in a unit. The integrated units can be implemented in the form of hardware or software functional units. In addition, the specific names of each functional unit and module are only used to distinguish each other, and are not used to limit the protection scope of the application. The specific working process of the units and modules in the above system can refer to the corresponding process in the above method embodiments, and will not be repeated here.

The embodiment of the present application provides a nuclear class electrical equipment, which includes the terminal described above.

In the above embodiments, the description of each embodiment has its own emphasis. For the part not detailed or recorded in one embodiment, please refer to the relevant description of other embodiments.

Those skilled in the art can realize that the units and algorithm steps of each example described in combination with the embodiments disclosed herein can be realized by electronic hardware, or the combination of computer software and electronic hardware. Whether these functions are implemented in hardware or software depends on the specific application and design constraints of the technical solution. Professionals and technicians can use different methods to realize the described functions for each specific application, but such implementation should not be considered beyond the scope of the present application.

In the embodiments provided by the present application, it should be understood that the disclosed devices/terminals and methods can be implemented in other ways. For example, the device/terminal embodiments described above are only schematic, for example, the division of the modules or units is only a logical function division, and there may be another division method when actually implemented, for example, multiple units or components can be combined or integrated into another system, or some features may be ignored or not implemented. On the other hand, the mutual coupling or direct coupling or communication connection shown or discussed may be indirect coupling or communication connection through some interfaces, devices or units, and may be electrical, mechanical or other forms.

The units described as separate units may or may not be physically separated, and the units displayed as units may or may not be physical units, that is, they may be located in one place or distributed to multiple network units. Some or all of the units can be selected according to actual needs to achieve the purpose of the embodiment.

In addition, each functional unit in each embodiment of the present application may be integrated in a processing unit, or each unit may exist physically independently, or two or more units may be integrated in a unit. The integrated units mentioned above may be realized in the form of hardware or software functional units.

If the integrated module/unit is realized in the form of software functional unit and sold or used as an independent product, it may be stored in a computer readable storage medium. Based on this understanding, the present application may realize all or part of the processes in the above embodiment method, and may also be completed by instructing related hardware through a computer program. The computer program may be stored in a non-transitory computer readable storage medium. When the computer program is executed by a processor, it may realize the steps of the above embodiments of the Forsmark effect monitoring method for the nuclear class electrical equipment. The computer program includes computer program code, which may be in the form of source code, object code, executable file or some intermediate forms. The computer-readable storage medium may include any entity or device capable of carrying the computer program code, recording medium, U disk, mobile hard disk, magnetic disk, optical disk, computer memory, read only memory (ROM), random access memory (RAM), electric carrier signal, telecommunication signal, software distribution medium, etc.. It should be noted that the contents contained in the computer readable storage medium may be appropriately increased or decreased according to the requirements of the legislation and patent practice in the jurisdiction. For example, in some jurisdictions, according to the legislation and patent practice, the computer readable storage medium does not include electric carrier signals and telecommunication signals.

The above embodiments are only used to explain the technical solution of the present application, not to limit it. Although the invention has been described in detail with reference to the preceding embodiments, those skilled in the art should understand that it can still modify the technical solutions recorded in the preceding embodiments, or equivalent replace some of the technical features. However, these modifications or substitutions do not make the essence of the corresponding technical solutions separate from the scope of the technical solutions of the embodiments of the present application, and should be included in the protection scope of the present application which is defined by the appended claims.

**Claims**

1. A Forsmark effect monitoring method for a nuclear class electrical equipment, comprising:

> acquiring (S201) a modulus value of a power grid voltage input to the nuclear class electrical equipment according to a preset monitoring period;
> matching (S202) a current monitoring period with a Yth monitoring period before the current monitoring period, and calculating a change ratio of the modulus value of the current monitoring period to the modulus value of a matched monitoring period; and
> when the change ratio corresponding to the current monitoring period and Y-1 change ratios corresponding to Y-1 monitoring periods before the current monitoring period are all greater than a change protection value, determining (S203) that the nuclear class electrical equipment will have the Forsmark effect;
> **characterized in that**
> calculating the change ratio of the modulus value of the current monitoring period to the modulus value of the matched monitoring period comprises:
>
>> calculating the change ratio of the modulus value of the current monitoring period to the modulus value of the matched monitoring period based on a change ratio calculation formula; and
>> the change ratio calculation formula is:

$$d_Z = \left| \frac{(\mathrm{MagBuf}[Z] - \mathrm{MagBuf}[Z-Y])}{\mathrm{MagBuf}[Z-Y]} \right|;$$

> wherein $d_Z$ represents the change ratio of the modulus value of a Zth monitoring period, MagBuf[Z] represents the modulus value of the Zth monitoring period, MagBuf[Z-Y] represents the modulus value of the Yth monitoring period before the Zth monitoring period; and
wherein acquiring the modulus value of the power grid voltage input to the nuclear class electrical equipment according to the preset monitoring period comprises:

calculating the modulus value of the power grid voltage input to the nuclear class electrical equipment based on a change calculation formula; and
the change calculation formula is:

$$\begin{cases} Alpha = [U_{uv} - 0.5(U_{vw} + U_{wu})] \cdot \sqrt{\dfrac{2}{3}} \\ Bete = [U_{uw} - U_{wu}] \cdot \sqrt{\dfrac{1}{2}} \\ Magnitude = Alpha \cdot Alpha + Bete \cdot Bete \end{cases} ;$$

wherein $U_{uv}$, $U_{uw}$ and $U_{wu}$ represent a three-phase voltage respectively; *Magnitude* represents the modulus value of the power grid voltage.

2. The method according to claim 1, wherein after determining that the nuclear class electrical equipment will have the Forsmark effect, the method further comprises:
power-off protecting the nuclear class electrical equipment.

3. The method according to claim 1, wherein after acquiring the modulus value of the power grid voltage input to the nuclear class electrical equipment according to the preset monitoring period, the method further comprises:
determining whether a first array has a remaining storage location; and when the first array has no the remaining storage location, deleting the modulus value of the monitoring period first stored in the first array, and storing the modulus value of the current monitoring period in a location of a newly deleted modulus value, the first array comprising at least 2Y storage locations.

4. The method according to claim 1, further comprising:

obtaining a mains protection time set by a user; and
determining a corresponding Y value based on the mains protection time.

5. A Forsmark effect monitoring device for a nuclear class electrical equipment, comprising:

a modulus value calculation module (110), being configured for acquiring a modulus value of a power grid voltage input to the nuclear class electrical equipment according to a preset monitoring period;
a change ratio calculation module (120), being configured for matching a current monitoring period with a Yth monitoring period before the current monitoring period, and calculating a change ratio of the modulus value of the current monitoring period to the modulus value of a matched monitoring period; and
a change monitoring module (130), being configured for when the change ratio corresponding to the current monitoring period and Y-1 change ratios corresponding to Y-1 monitoring periods before the current monitoring period are all greater than a change protection value, determining that the nuclear class electrical equipment will have the Forsmark effect;
**characterized in that**
the change ratio calculation module (120) is specifically configured for:

calculating the change ratio of the modulus value of the current monitoring period to the modulus value of the matched monitoring period based on a change ratio calculation formula; and
the change ratio calculation formula is:

$$d_Z = \left| \frac{(MagBuf[Z] - MagBuf[Z-Y])}{MagBuf[Z-Y]} \right| ;$$

wherein $d_Z$ represents the change ratio of the modulus value of a Zth monitoring period, MagBuf[Z] represents the modulus value of the Zth monitoring period, MagBuf[Z-Y] represents the modulus value of the Yth monitoring period before the Zth monitoring period; and
wherein the modulus value calculation module (110) is specifically configured for:

calculating the modulus value of the power grid voltage input to the nuclear class electrical equipment based on a change calculation formula; and
the change calculation formula is:

$$\begin{cases} Alpha = [U_{uv} - 0.5(U_{vw} + U_{wu})] \cdot \sqrt{\dfrac{2}{3}} \\ Bete = [U_{uw} - U_{wu}] \cdot \sqrt{\dfrac{1}{2}} \\ Magnitude = Alpha \cdot Alpha + Bete \cdot Bete \end{cases} ;$$

wherein $U_{uv}$, $U_{uw}$ and $U_{wu}$ represent a three-phase voltage respectively; *Magnitude* represents the modulus value of the power grid voltage.

6. The device according to claim 5, further comprising a power-off protection module, being configured for:
power-off protecting the nuclear class electrical equipment.

7. The device according to claim 5, further comprising a modulus value storage module, being configured for:
determining whether a first array has a remaining storage location; and when the first array has no the remaining storage location, deleting the modulus value of the monitoring period first stored in the first array, and storing the modulus value of the current monitoring period in a location of a newly deleted modulus value, the first array comprising at least 2Y storage locations.

8. The device according to claim 5, further comprising a Y value setting module, being configured for:

obtaining a mains protection time set by a user; and
determining a corresponding Y value based on the mains protection time.

9. A non-transitory computer readable storage medium, the non-transitory computer readable storage medium storing a computer program, wherein when the computer program is executed by a processor, steps of the method of anyone of claims 1 to 4 are realized.

**Patentansprüche**

1. Forsmark-Effekt-Überwachungsverfahren für elektrische Ausrüstung der Nuklearklasse, umfassend:

Erfassen (S201) eines Modulwertes einer Stromnetzspannung, die in die elektrische Ausrüstung der Nuklearklasse eingespeist wird, gemäß einem voreingestellten Überwachungszeitraum;
Abgleichen (S202) eines momentanen Überwachungszeitraums mit einem Y-ten Überwachungszeitraum vor dem momentanen Überwachungszeitraum und Berechnen eines Änderungsverhältnisses des Modulwertes des momentanen Überwachungszeitraums zu dem Modulwert eines abgeglichenen Überwachungszeitraums; und wenn das Änderungsverhältnis, das dem momentanen Überwachungszeitraum entspricht, und Y-1 Änderungsverhältnisse, die Y-1 Überwachungszeiträumen vor dem momentanen Überwachungszeitraum entsprechen, alle größer als ein Änderungsschutzwert sind, Bestimmen (S203), dass die elektrische Ausrüstung der Nuklearklasse den Forsmark-Effekt aufweisen wird;
**dadurch gekennzeichnet, dass**
das Berechnen des Änderungsverhältnisses des Modulwertes des momentanen Überwachungszeitraums zu dem Modulwert des abgeglichenen Überwachungszeitraums umfasst:

Berechnen des Änderungsverhältnisses des Modulwertes des momentanen Überwachungszeitraums zu dem Modulwert des abgeglichenen Überwachungszeitraums auf der Grundlage einer Änderungsverhältnisberechnungsformel; und
wobei die Änderungsverhältnisberechnungsformel lautet:

$$d_Z = \left| \frac{(MagBuf[Z] - MagBuf[Z-Y])}{MagBuf[Z-Y]} \right|;$$

wobei $d_Z$ das Änderungsverhältnis des Modulwertes eines Z-ten Überwachungszeitraums darstellt, MagBuf[Z] den Modulwert des Z-ten Überwachungszeitraums darstellt, MagBuf[Z-Y] den Modulwert des Y-ten Überwachungszeitraums vor dem Z-ten Überwachungszeitraum darstellt; und
wobei das Erfassen des Modulwertes der Stromnetzspannung, die in die elektrische Ausrüstung der Nuklearklasse eingespeist wird, gemäß dem voreingestellten Überwachungszeitraum umfasst:

Berechnen des Modulwertes der Stromnetzspannung, die in die elektrische Ausrüstung der Nuklearklasse eingespeist wird, auf der Grundlage einer Änderungsberechnungsformel; und
wobei die Änderungsberechnungsformel lautet:

$$\begin{cases} Alpha = [U_{uv} - 0.5(U_{vw} + U_{wu})] \cdot \sqrt{\frac{2}{3}} \\ Bete = [U_{uw} - U_{wu}] \cdot \sqrt{\frac{1}{2}} \\ Magnitude = Alpha \cdot Alpha + Bete \cdot Bete \end{cases};$$

wobei $U_{uv}$, $U_{uw}$ und $U_{wu}$ jeweils eine dreiphasige Spannung darstellen; *Magnitude* den Modulwert der Stromnetzspannung darstellt.

2. Verfahren nach Anspruch 1, wobei nach dem Bestimmen, dass die elektrische Ausrüstung der Nuklearklasse den Forsmark-Effekt aufweisen wird, das Verfahren des Weiteren umfasst:
Abschalt-Schützen der elektrischen Ausrüstung der Nuklearklasse.

3. Verfahren nach Anspruch 1, wobei nach dem Erfassen des Modulwertes der Stromnetzspannung, die in die elektrische Ausrüstung der Nuklearklasse eingespeist wird, gemäß dem voreingestellten Überwachungszeitraum das Verfahren des Weiteren umfasst:
Bestimmen, ob ein erstes Array einen verbleibenden Speicherort hat; und wenn das erste Array nicht den verbleibenden Speicherort hat, Löschen des Modulwertes des Überwachungszeitraums, der zuerst in dem ersten Array gespeichert wurde, und Speichern des Modulwertes des momentanen Überwachungszeitraums an einem Ort eines neu gelöschten Modulwertes, wobei das erste Array mindestens 2Y Speicherorte umfasst.

4. Verfahren nach Anspruch 1, des Weiteren umfassend:

Erhalten einer durch einen Benutzer eingestellten Netzschutzzeit; und
Bestimmen eines entsprechenden Y-Wertes auf der Grundlage der Netzschutzzeit.

5. Forsmark-Effekt-Überwachungsvorrichtung für elektrische Ausrüstung der Nuklearklasse, umfassend:

ein Modulwertberechnungsmodul (110), das dazu eingerichtet ist, einen Modulwert einer Stromnetzspannung, die in die elektrische Ausrüstung der Nuklearklasse eingespeist wird, gemäß einem voreingestellten Überwachungszeitraum zu erfassen;

ein Änderungsverhältnisberechnungsmodul (120), das dazu eingerichtet ist, einen momentanen Überwachungszeitraum mit einem Y-ten Überwachungszeitraum vor dem momentanen Überwachungszeitraum abzugleichen und ein Änderungsverhältnis des Modulwertes des momentanen Überwachungszeitraums zu dem Modulwert eines abgeglichenen Überwachungszeitraums zu berechnen; und

ein Änderungsüberwachungsmodul (130), das dazu eingerichtet ist zu bestimmen, dass die elektrische Ausrüstung der Nuklearklasse den Forsmark-Effekt aufweisen wird, wenn das Änderungsverhältnis, das dem momentanen Überwachungszeitraum entspricht und Y-1 Änderungsverhältnisse, die Y-1 Überwachungszeiträumen vor dem momentanen Überwachungszeitraum entsprechen, alle größer als ein Änderungsschutzwert sind;

**dadurch gekennzeichnet, dass**

das Änderungsverhältnisberechnungsmodul (120) speziell eingerichtet ist zum:

Berechnen des Änderungsverhältnisses des Modulwertes des momentanen Überwachungszeitraums zu dem Modulwert des abgeglichenen Überwachungszeitraums auf der Grundlage einer Änderungsverhältnisberechnungsformel; und

wobei die Änderungsverhältnisberechnungsformel lautet:

$$d_Z = \left| \frac{(\mathrm{MagBuf}[Z] - \mathrm{MagBuf}[Z-Y])}{\mathrm{MagBuf}[Z-Y]} \right|;$$

wobei $d_Z$ das Änderungsverhältnis des Modulwertes eines Z-ten Überwachungszeitraums darstellt, MagBuf[Z] den Modulwert des Z-ten Überwachungszeitraums darstellt, MagBuf[Z-Y] den Modulwert des Y-ten Überwachungszeitraums vor dem Z-ten Überwachungszeitraum darstellt; und

wobei das Modulwertberechnungsmodul (110) speziell eingerichtet ist zum:

Berechnen des Modulwertes der Stromnetzspannung, die in die elektrische Ausrüstung der Nuklearklasse eingespeist wird, auf der Grundlage einer Änderungsberechnungsformel; und

wobei die Änderungsberechnungsformel lautet:

$$\begin{cases} Alpha = [U_{uv} - 0.5(U_{vw} + U_{wu})] \cdot \sqrt{\frac{2}{3}} \\ Bete = [U_{vw} - U_{wu}] \cdot \sqrt{\frac{1}{2}} \\ Magnitude = Alpha \cdot Alpha + Bete \cdot Bete \end{cases};$$

wobei $U_{uv}$, $U_{uw}$ und $U_{wu}$ jeweils eine dreiphasige Spannung darstellen; *Magnitude* den Modulwert der Stromnetzspannung darstellt.

6. Vorrichtung nach Anspruch 5, des Weiteren umfassend ein Abschaltschutzmodul, das eingerichtet ist zum: Abschalt-Schützen der elektrischen Ausrüstung der Nuklearklasse.

7. Vorrichtung nach Anspruch 5, des Weiteren umfassend ein Modulwertspeichermodul, das eingerichtet ist zum: Bestimmen, ob ein erstes Array einen verbleibenden Speicherort hat; und wenn das erste Array nicht den verbleibenden Speicherort hat, Löschen des Modulwertes des Überwachungszeitraums, der zuerst in dem ersten Array gespeichert wurde, und Speichern des Modulwertes des momentanen Überwachungszeitraums an einem Ort eines neu gelöschten Modulwertes, wobei das erste Array mindestens 2Y Speicherorte umfasst.

8. Vorrichtung nach Anspruch 5, des Weiteren umfassend ein Y-Wert-Einstellmodul, das eingerichtet ist zum:

Erhalten einer durch einen Benutzer eingestellten Netzschutzzeit; und
Bestimmen eines entsprechenden Y-Wertes auf der Grundlage der Netzschutzzeit.

9. Nicht-transitorisches computerlesbares Speichermedium, wobei das nichttransitorische computerlesbare Speichermedium ein Computerprogramm speichert, wobei, wenn das Computerprogramm durch einen Prozessor ausgeführt wird, Schritte des Verfahrens nach einem der Ansprüche 1 bis 4 realisiert werden.

**Revendications**

1. Procédé de suivi à effet Forsmark pour équipement électrique de classe nucléaire, comprenant :

   l'acquisition (S201) d'une valeur de module d'une tension du réseau électrique introduite dans l'équipement électrique de classe nucléaire selon une période de suivi préréglée ;
   la mise en correspondance (S202) d'une période de suivi instantanée avec une Yème période de suivi avant la période de suivi instantanée, et le calcul d'un rapport de changement de la valeur de module de la période de suivi instantanée sur la valeur de module d'une période de suivi mise en correspondance ; et
   lorsque le rapport de changement correspondant à la période de suivi instantanée et les Y-1 rapports de changement correspondant aux Y-1 périodes de suivi avant la période de suivi instantanée sont tous plus grands qu'une valeur de protection de changement, la détermination (S203) que l'équipement électrique de classe nucléaire aura l'effet Forsmark ;
   **caractérisé en ce que**
   le calcul du rapport de changement de la valeur de module de la période de suivi instantanée sur la valeur de module de la période de suivi mise en correspondance comprend :

      le calcul du rapport de changement de la valeur de module de la période de suivi instantanée sur la valeur de module de la période de suivi mise en correspondance sur la base d'une formule de calcul de rapport de changement ; et
      dans lequel la formule de calcul de rapport de changement est :

$$d_Z = \left| \frac{(MagBuf[Z] - MagBuf[Z-Y])}{MagBuf[Z-Y]} \right| ;$$

   où $d_Z$ représente le rapport de changement de la valeur de module d'une Zème période de suivi, $MagBuf[Z]$ représente la valeur de module de la Zème période de suivi, $MagBuf[Z-Y]$ représente la valeur de module de la Yème période de suivi avant la Zème période de suivi ; et
   dans lequel l'acquisition de la valeur de module de la tension du réseau électrique introduite dans l'équipement électrique de classe nucléaire selon la période de suivi préréglée comprend :

      le calcul de la valeur de module de la tension du réseau électrique introduite dans l'équipement électrique de classe nucléaire sur la base d'une formule de calcul de changement ; et
      dans lequel la formule d calcul de changement est :

$$\begin{cases} Alpha = [U_{uv} - 0.5(U_{vw} + U_{uw})] \cdot \sqrt{\frac{2}{3}} \\ Bete = [U_{vw} - U_{uw}] \cdot \sqrt{\frac{1}{2}} \\ Magnitude = Alpha \cdot Alpha + Bete \cdot Bete \end{cases} ;$$

   où $U_{uv}$, $U_{uw}$ et $U_{vw}$ représentent une tension à trois phases respectivement ; *Magnitude* représente la valeur de module de la tension de grille d'énergie.

2. Procédé selon la revendication 1, dans lequel après la détermination que l'équipement électrique de classe nucléaire aura l'effet Forsmark, le procédé comprend en outre :
   la protection par mise hors tension de l'équipement électrique de classe nucléaire.

3. Procédé selon la revendication 1, dans lequel après l'acquisition de la valeur de module de la tension du réseau électrique introduite dans l'équipement électrique de classe nucléaire selon la période de suivi préréglée, le procédé comprend en outre :

la détermination si un premier réseau a un site de stockage restant ; et lorsque le premier réseau n'a pas le site de stockage restant, la délétion de la valeur de module de la période de suivi stockée en premier dans le premier réseau et le stockage de la valeur de module de la période de suivi instantanée dans un site d'une valeur de module nouvellement délétée, le premier réseau comprenant au moins 2Y sites de stockage.

4. Procédé selon la revendication 1, comprenant en outre :

l'obtention d'un temps de protection du réseau réglé par un utilisateur ; et
la détermination d'une valeur Y correspondante sur la base du temps de protection du réseau.

5. Dispositif de suivi d'effet Forsmark pour équipement électrique de classe nucléaire, comprenant :

un module de calcul de valeur de module (110), étant configuré pour acquérir une valeur de module d'une tension du réseau électrique introduite dans l'équipement électrique de classe nucléaire selon une période de suivi préréglée ;
un module de calcul de rapport de changement (120), étant configuré pour mettre en correspondance une période de suivi instantanée avec une Yème période de suivi avant la période de suivi instantanée et pour calculer un rapport de changement de la valeur de module de la période de suivi instantanée sur la valeur de module d'une période de suivi mise en correspondance ; et
un module de suivi de changement (130), étant configuré pour déterminer que l'équipement électrique de classe nucléaire aura l'effet Forsmark lorsque le rapport de changement correspondant à la période de suivi instantanée et les Y-1 rapports de changement correspondant aux Y-1 périodes de suivi avant la période de suivi instantanée sont tous plus grands qu'une valeur de protection de changement ;
**caractérisé en ce que**
le module de calcul de rapport de changement (120) est spécifiquement configuré pour :

calculer le rapport de changement de la valeur de module de la période de suivi instantanée sur la valeur de module de la période de suivi mise en correspondance sur la base d'une formule de calcul de rapport de changement ; et
la formule de calcul de rapport e changement est :

$$d_Z = \left| \frac{(\mathrm{MagBuf}[Z] - \mathrm{MagBuf}[Z - Y])}{\mathrm{MagBuf}[Z - Y]} \right| ;$$

où $d_Z$ représente le rapport de changement de la valeur de module d'une Zème période de suivi, MagBuf[Z] représente la valeur de module de la Zème période de suivi, MagBuf[Z - Y] représente la valeur de module de la Yème période de suivi avant la Zème période de suivi ; et
dans lequel le module de calcul de valeur de module (110) est spécifiquement configuré pour :

calculer la valeur de module de la tension du réseau électrique introduite dans l'équipement électrique de classe nucléaire sur la base d'une formule de calcul de changement ; et
dans lequel la formule d calcul de changement est :

$$\begin{cases} Alpha = [U_{uv} - 0.5(U_{vw} + U_{uw})] \cdot \sqrt{\frac{2}{3}} \\ Bete = [U_{vw} - U_{uw}] \cdot \sqrt{\frac{1}{2}} \\ Magnitude = Alpha \cdot Alpha + Bete \cdot Bete \end{cases} ;$$

où $U_{uv}$, $U_{uw}$ et $U_{vw}$ représentent une tension à trois phases respectivement ; *Magnitude* représente la valeur de module de la tension de grille d'énergie.

6. Dispositif selon la revendication 5, comprenant en outre un module de protection par mise hors tension, étant configuré pour :
la protection par mise hors tension de l'équipement électrique de classe nucléaire.

7. Dispositif selon la revendication 5, comprenant en outre un module de stockage de valeur de module, configuré pour : déterminer si un premier réseau a un site de stockage restant ; et lorsque le premier réseau n'a pas le site de stockage restant, déléter la valeur de module de la période de suivi stockée en premier dans le premier réseau, et stocker la valeur de module de la période de suivi instantanée dans un site d'une valeur de module nouvellement délétée, le premier réseau comprenant au moins 2Y sites de stockage.

8. Dispositif selon la revendication 5, comprenant en outre un module de réglage de valeur Y, étant configuré pour :

obtenir un temps de protection du réseau réglé par un utilisateur ; et
déterminer une valeur Y correspondante sur la base du temps de protection du réseau.

9. Support de stockage lisible sur ordinateur non transitoire, le support de stockage lisible sur ordinateur non transitoire stockant un programme informatique, dans lequel, lorsque le programme informatique est exécuté par un processeur, des étapes du procédé selon l'une quelconque des revendications 1 à 4 sont réalisées.

10

| connected power grid | | rectifier module | DC bus | load |

Fig. 1

acquiring a modulus value of a power grid voltage input to the nuclear class electrical equipment according to a preset monitoring period — S201

matching a current monitoring period with a Yth monitoring period before the current monitoring period, and calculating a change ratio of the modulus value of the current monitoring period to the modulus value of a matched monitoring period — S202

when the change ratio corresponding to the current monitoring period and Y-1 change ratios corresponding to Y-1 monitoring periods before the current monitoring period are all greater than a change protection value, determining that the nuclear class electrical equipment will have the Forsmark effect — S203

Fig. 2

mains modulus

No.5 detection point    No.6 detection point    No.7 detection point    No.8 detection point    No.9 detection point    No.10 detection point

fabs((MagBuf[10] - MagBuf[7])/ MagBuf[7]) > 0.5

fabs((MagBuf[9] - MagBuf[6])/ MagBuf[6]) > 0.5

fabs((MagBuf[8] - MagBuf[5])/ MagBuf[5]) > 0.5

Fig. 3

100

110
modulus calculation module

120
change ratio calculation module

130
change monitoring module

Fig. 4

5

50
51

non-transitory memory
52

computer program

processor

terminal

Fig. 5

**EP 4 362 255 B1**

**REFERENCES CITED IN THE DESCRIPTION**

**Patent documents cited in the description**

- WO 2021099413 A1
- WO 2022223759 A1
- WO 2021175793 A1
- WO 2021196627 A1

**Non-patent literature cited in the description**

- NPP Voltage Surge Protection. **DR. JOHN H. BICKEL**. IEEE DRAFT, NPEC_JULY-2012_HBICKEL_NPP VOLTAGE SURGE PROTECTION. IEEE-SA, 04 August 2012, vol. npec, 1-18